# EUROPÄISCHE PATENTANMELDUNG

(11) **EP 1 168 905 A2**
(43) Veröffentlichungstag der Anmeldung: **02.01.2002**
(21) Anmeldenummer: 01114901.0
(22) Anmeldetag: 19.06.2001
(51) Int. Cl.: H05K 7/14

(54) **Baugruppenträger und Verbundbaugruppenträger**

(30) Priorität: 20.06.2000 DE 10030233
(71) Anmelder: SIEMENS AKTIENGESELLSCHAFT, 80333 München (DE)
(72) Erfinder: Mair, Eduard, 81477 München (DE); Sedlmeier, Peter, 81669 München (DE)

(57) **Zusammenfassung**

Die Erfindung betrifft einen Baugruppenträger (9) für einen Verbundbaugruppenträger (14) zur Aufnahme von Baugruppen. Weiterhin betrifft die Erfindung einen Verbundbaugruppenträger (14) mit zumindest zwei senkrecht übereinander angeordneten Baugruppenträgern (9).

Die Erfindung zeichnet sich dadurch aus, daß der Verbundbaugruppenträger (14) mindestens zwei Baugruppenträger (9) enthält, deren Oberseite (20) und Unterseite (24) jeweils mit mindestens einem großflächigen Durchbruch (13) versehen sind, sowie zwei Schirmbleche (7) vorgesehen sind, die die Oberseite (20) des obenliegenden Baugruppenträgers (9) und die Unterseite (24) des untenliegenden Baugrupenträgers (9) abschirmen.

## Beschreibung

Die Erfindung betrifft einen Baugruppenträger für einen Verbundbaugruppenträger mit zwei Seitenwänden, einer Oberseite, einer Unterseite, einer Vorderseite und einer Rückwand, zur Aufnahme von Baugruppen. Weiterhin betrifft die Erfindung einen Verbundbaugruppenträger mit zumindest zwei senkrecht übereinander angeordneten Baugruppenträgern, wobei die Baugruppenträger zwei Seitenwände, eine Oberseite, eine Unterseite, eine Vorderseite und eine Rückwand aufweisen, zur Aufnahme von Baugruppen.

Ein Baugruppenträger ist ein Gehäuse, das eine Anzahl Baugruppen in sich aufnehmen kann. Die Rückwand (Backplane) des Baugruppenträgers verbindet bei einem geschirmten Baugruppenträger die gesteckten Baugruppen elektrisch miteinander und verfügt über integrierte Schirmlagen, das heißt, vollflächige, elektrisch leitende, in der Leiterplatte mitverpresste Ebenen, die an allen Plattenrändern elektrisch mit dem Gehäuse kontaktiert sind. Die Verdrahtungsplatte sollte, ebenso wie das metallische Gehäuse des Baugruppenträgers, dicht gegen ein Ein- beziehungsweise Aussenden von hochfrequenten elektrischen Wellen sein. Eine abnehmbare Frontabdeckung schließt den Baugruppenträger zur Bedienseite ab, ein Bodenund ein Deckblech sind großflächig perforiert, um einen möglichst hohen Luftdurchsatz zum Abführen der Verlustleistung der Baugruppen, das heißt eine gute Entwärmung des Baugruppenträgers, zu erreichen.

Elektrisch soll der Baugruppenträger einen Faradayschen Käfig um die Baugruppen herum bilden, da es Störaussendung und Störeinstrahlung von und auf diese Baugruppen zu vermeiden beziehungsweise abzuschirmen gilt.

Hierbei stellt sich allerdings das Problem, daß sich die Schirmgüte und die Entwärmbarkeit des Baugruppenträgers entgegengesetzt verhalten. Für eine Verbesserung der Entwärmbarkeit müßte der Strömungswiderstand für die den Baugruppenträger durchströmende Luft verringert werden. Dies kann durch eine Erhöhung der Offenheit der Perforation der Bodenund Deckbleche erreicht werden. Hierbei wird allerdings eine Verschlechterung der Schirmgüte des Baugruppenträgers in Kauf genommen.

Wenn die Abführung der Verlustleistung durch freie Konvektion nicht mehr möglich ist, werden Ventilatoren eingebaut. Allerdings ist hierbei von Nachteil, daß die Ventilator-Einsätze einen erheblichen Platz beanspruchen.

Ein Verbundbaugruppenträger ist ein Gestellschrank, in dem üblicherweise mehrere Baugruppenträger senkrecht übereinander eingebaut sind. Jeder einzelne Baugruppenträger saugt seine Kühlluft von der Unterseite an und gibt sie nach oben wieder ab. Die Luft passiert also bei jedem Überströmen in den nächsten geschirmten Baugruppenträger zwei Widerstandszonen, nämlich jeweils das Deck- und das Bodenblech. Bei einer Vollbestückung eines Verbundbaugruppenträgers mit acht zweizeiligen Baugruppenträgern addiert sich der Strömungswiderstand also insgesamt sechzehn Mal und eine effektive Entwärmbarkeit ist problematisch.

Es ist daher Aufgabe der Erfindung, einen Baugruppenträger für einen Verbundbaugruppenträger und einen Verbundbaugruppenträger zu entwickeln, die eine Verbesserung der Entwärmbarkeit beim Einbau der Baugruppenträger in den Verbundbaugruppenträger ergeben, ohne daß die elektrische Abschirmung der Baugruppen innerhalb des Baugruppenträgers beeinträchtigt wird.

Die Aufgabe zur Entwicklung eines Baugruppenträgers und eines Verbundbaugruppenträgers wird durch die Merkmale der unabhängigen Vorrichtungsansprüche gelöst.

Die Erfinder haben erkannt, daß die Deck- und Bodenbleche der Baugruppenträger, die sich im Innern des Verbundbaugruppenträgers befinden, für eine elektrische Abschirmung der Baugruppen nicht benötigt werden, wenn der Verbundbaugruppenträger selbst einen Faradayschen Käfig bildet. Werden diese Deck- und Bodenbleche also großflächig durchbrochen, sind sie nun im Hinblick auf eine Strömung der Luft nicht mehr relevant beziehungsweise behindern die freie Konvektion der Luft nicht mehr, wobei die Baugruppen innerhalb des Baugruppenträgers jedoch weiterhin elektrisch abgeschirmt sind.

Gemäß dieser Erkenntnis schlagen die Erfinder vor, einen Baugruppenträger für einen Verbundbaugruppenträger mit zwei Seitenwänden, einer Oberseite, einer Unterseite, einer Vorderseite und einer Rückwand, zur Aufnahme von Baugruppen, dahingehend weiterzuentwickeln, daß sowohl die Oberseite als auch die Unterseite des Baugruppenträgers jeweils mit mindestens einem großflächigen Durchbruch versehen sind. Vorteilhaft sind zwischen drei bis neun großflächige Durchbrüche vorgesehen, so daß Streben auf der Ober- und der Unterseite des Baugruppenträgers verbleiben, die stabilisierend wirken.

Dieser erfindungsgemäße Baugruppenträger stellt ein Grundelement dar, das nun an seiner Oberseite und an seiner Unterseite keine EMV-wirksamen (EMV = elektromagnetische Verträglichkeit) Begrenzungen mehr besitzt.

In einer vorteilhaften Ausgestaltung des erfindungsgemäßen Baugruppenträgers weist die Fläche des mindestens einen großflächigen Durchbruchs zwischen 50% und 90%, vorzugsweise zwischen 70% und 90%, der gesamten Fläche der Oberseite oder der Unterseite des Baugruppenträgers auf.

Eine weitere Ausgestaltung des Baugruppenträgers sieht vor, daß, vorzugsweise randständige, Stege auf der Oberseite und auf der Unterseite des Baugruppenträgers vorgesehen sind. Vorteilhaft weisen die Stege, zumindest teilweise, eine Lochung auf. Diese Lochung kann zum Beispiel zur Befestigung anderer Teile an den Baugruppenträger verwendet werden.

Eine besonders vorteilhafte Ausführung des erfindungsgemäßen Baugruppenträgers sieht auf der zur Oberseite gelegenen Kante jeder Seitenwand des Baugruppenträgers Kontaktierungsmittel vor. Diese Kontaktierungsmittel sind derart ausgestaltet, daß sie auf die Kanten der Seitenwand aufgeschnappt werden können.

Weiterhin können auf der Oberseite, zur Vorderseite des Baugruppenträgers hin gelegen, Kontaktierungsmittel vorgesehen sein, die vorzugsweise aus zwei kammförmigen Federn bestehen. Diese werden vorzugsweise u-förmig angeordnet. Zur Befestigung der Federn auf dem erfindungsgemäßen Baugruppenträger ist eine Strebe vorgesehen, die die Seitenwände miteinander verbindet. An diese Strebe werden die Kontaktierungsmittel in vorteilhafter Weise befestigt, beispielsweise aufgeschraubt.

In einer anderen Weiterentwicklung sind auf der Oberseite, zur Rückwand des Baugruppenträgers hin gelegen, weitere Kontaktierungsmittel vorgesehen. Diese weisen in einer bevorzugten Ausführung eine dreieckige Form auf und können mit Hilfe einer Schiene auf der Oberseite des Baugruppenträgers befestigt werden, wobei die Federn vorteilhaft lediglich über die Schiene geschoben werden.

In einer Weiterentwicklung des erfindungsgemäßen Baugruppenträgers ist eine Frontabdeckung mit Kontaktierungsmitteln vorgesehen, die den Baugruppenträger kontaktieren. Die Frontabdeckung schließt zur Bedienseite den Baugruppenträger ab.

Das Kontaktierungsmittel ist vorzugsweise elastisch und elektrisch leitend ausgebildet. So kann das Kontaktierungsmittel eine, vorzugsweise metallische, Kontaktfeder darstellen. Unter Kontaktierung wird auch im folgenden eine elektrische Kontaktierung verstanden.

Eine weitere vorteilhafte Ausgestaltung sieht mindestens ein, vorzugsweise zwei, Schirmbleche vor, die den mindestens einen großflächigen Durchbruch der Oberseite und/oder der Unterseite des Baugruppenträgers abschirmen.

In einer vorteilhaften Weiterentwicklung des erfindungsgemäßen Baugruppenträgers weist das Schirmblech, zumindest teilweise, eine Lochung auf. Hierdurch ist eine einfache Montage des Schirmblechs auf der Oberseite und der Unterseite des Baugruppenträgers, beispielsweise mittels Schrauben oder Nieten, möglich.

Darüber hinaus kann das Schirmblech eine Vielzahl von regelmäßig verteilten Löchern (Perforation) aufweisen, wobei die gesamte offene Fläche der Löcher (Offenheit) im Bereich zwischen 50% und 80%, vorzugsweise zwischen 65% und 75%, der gesamten Fläche des Schirmblechs liegt. Vorzugsweise ist diese offene Fläche der Löcher möglichst groß, um eine optimale Entwärmbarkeit zu erreichen, wobei die Lochgröße abhängig ist von der abzuschirmenden Frequenz. Je höher die Frequenz ist, um so geringer sollte die Lochgröße sein. Eine vorteilhafte Ausgestaltung des Schirmbleches sieht vor, daß zur Abschirmung einer Frequenz von 0 bis zu 1 GHz die Löcher des Schirmbleches einen Durchmesser von vorzugsweise zirka 4 mm haben.

Um eine Stabilität des Schirmbleches zu gewährleisten, ist die Verteilung der Löcher von der Festigkeit des verwendeten Materials abhängig. Bei hochfesten Materialien kann die offene Fläche der Löcher an der oberen Grenze, das heißt bei zirka 80%, liegen.

Darüber hinaus hängt eine optimale Entwärmbarkeit von der Ausdehnung der Perforationsfläche ab. Vorzugsweise liegt diese Ausdehnung im Bereich zwischen 80% und 95% der gesamten Fläche des Schirmblechs.

Durch die erfindungsgemäße Ausgestaltung des Schirmbleches wird somit neben einem hohen Luftdurchsatz durch den Baugruppenträger dennoch eine hohe elektrische Abschirmung gewährleistet. Insbesondere die Frequenzen des Mobilfunkbereiches werden zuverlässig abgeschirmt.

Weiterhin kann das Schirmblech, zumindest an der zur Vorderseite des Baugruppenträgers weisenden Kante, mindestens ein, vorzugsweise mehrere, Kontaktierungsmittel, zur Kontaktierung des Schirmblechs, zumindest mit dem Baugruppenträger, aufweisen. Vorzugsweise stellt das Kontaktierungsmittel eine Kontaktfeder dar, die kammförmig ausgebildet sein kann.

Mit diesen erfindungsgemäßen Ausgestaltungen ist der Baugruppenträger nun ein EMV-wirksames Gehäuse, das für die Baugruppen innerhalb des Baugruppenträgers einen Faradayschen Käfig darstellt.

Die Erfinder schlagen weiterhin vor, einen Verbundbaugruppenträger mit zumindest zwei senkrecht übereinander angeordneten Baugruppenträgern, wobei die Baugruppenträger zwei Seitenwände, eine Oberseite, eine Unterseite, eine Vorderseite und eine Rückwand aufweisen, zur Aufnahme von Baugruppen, dahingehend weiterzuentwickeln, daß mindestens zwei Baugruppenträger, vorzugsweise alle Baugruppenträger, erfindungsgemäß, wie voranstehend beschrieben, ausgebildet sind und weiterhin zwei Schirmbleche vorgesehen sind, die die Oberseite des obenliegenden Baugruppenträgers und/oder die Unterseite des untenliegenden Baugruppenträgers abschirmen. Auch diese Schirmbleche sind erfindungsgemäß, wie voranstehend beschrieben, ausgestaltet. Die Schirmbleche werden also erfindungsgemäß an dem untersten Baugruppenträgerboden und an der obersten Baugruppenträgerdecke angebracht.

Die für Baugruppenführungen erforderlichen Zwischenebenen (also die Ober- und die Unterseiten der Baugruppenträger, die sich im Innern des Verbundbaugruppenträgers befinden) sind großflächig durchbrochen und sind nun im Hinblick auf eine Strömung der Luft nicht mehr relevant beziehungsweise behindern die freie Konvektion der Luft nicht mehr.

Der Aufbau des Verbundbaugruppenträgers kann nun variieren von zwei Baugruppenträgern bis zum Vollausbau, also beispielsweise acht Baugruppenträgern. Die Erfindung sieht auch ein Nachrüsten oder Austauschen von einzelnen Baugruppenträgern in dem Verbundbaugruppenträger vor.

Erfindungsgemäß wird die Höhenteilung von eingeführten Bauweisen nicht überschritten, um abwärtskompatibel zu sein. Hierdurch wird ein Austausch von Baugruppenträgern, alt gegen neu, ermöglicht, auch wenn diese sich in der Mitte des Verbundbaugruppenträgers befinden. Die Höhe des frei werdenden Einbauplatzes entspricht also vorteilhaft der Höhe des neuen Baugruppenträgers. Die eingeführten Bauweisen der bestehenden Baugruppenträger sind also mit den erfindungsgemäßen Baugruppenträgern kompatibel.

Weiterhin ist die elektrische Kontaktierung über alle Baugruppenträger, bis zu den Enden des Verbundbaugruppenträgers, durchgängig.

Es wird also erreicht, daß die erfindungsgemäßen Baugruppenträger in dem Verbundbaugruppenträger in einer Weise senkrecht aneinander gekoppelt werden können, daß sie elektrisch zu einem einzigen Schirmgehäuse verbunden werden. Mit Ausnahme des untersten Bodenbleches und des obersten Deckbleches (die jeweils ein erfindungsgemäß ausgestaltetes Schirmblech darstellen können) sind in den horizontalen Ebenen keine weiteren Bleche zur Schirmung mehr erforderlich. Der Gesamtströmungswiderstand wird damit erheblich reduziert und ermöglicht einen hohen Luftdurchsatz.

Ein Schirmblech mit einer bekannten Lochgeometrie, zum Beispiel ein 60° V-Raster 5x4^{⌀}, besitzt einen Strömungswiderstand von zirka 3. Im Vergleich zu Baugruppen, deren Zielwert unterhalb 8 liegt, zeigt sich, daß der Strömungswiderstand zweier Lochbleche in der gleichen Größenordnung liegt und damit die freie Konvektion wesentlich beeinflußt. Der erfindungsgemäße Verbundbaugruppenträger wirkt ähnlich wie ein Kamin und bietet eine deutlich erhöhte Entwärmungskapazität.

Eine vorteilhafte Weiterentwicklung des erfindungsgemäßen Verbundbaugruppenträgers sieht zwischen zwei Baugruppenträgern einen Verbindungsrahmen vor. Zu vorhandenen bekannten Baugruppenträgern können dann die erfindungsgemäßen Baugruppenträger als Verbundbaugruppenträger nachgerüstet werden, so daß durch einen Austausch von mindestens zwei oder mehr Baugruppenträgern eine deutliche Verbesserung der Entwärmbarkeit erreicht wird.

In einer Ausgestaltung des erfindungsgemäßen Verbundbaugruppenträgers weist der Verbindungsrahmen, zumindest teilweise, eine Lochung zur Befestigung an einem der beiden angrenzenden Baugruppenträger auf. Der Verbindungsrahmen kann an die Stege der Ober- oder der Unterseite eines ersten Baugruppenträgers fest montiert, beispielsweise geschraubt werden.

Weiterhin kann der Verbindungsrahmen erfindungsgemäß eine Vielzahl von Kontaktierungsmitteln aufweisen, die an der Oberseite oder an der Unterseite des Verbindungsrahmens angeordnet sind. Die Kontaktierungsmittel kontaktieren hierbei mit den Stegen des zweiten Baugruppenträgers, in einer Weise, so daß keine starre, mechanische Verbindung entsteht.

Durch diese Ausgestaltung wird erreicht, daß keine größere starre Anordnung gebildet wird, damit zum einen Toleranzen ausgeglichen werden können und zum anderen bei mechanischen Beanspruchungen, wie sie zum Beispiel durch Erdbeben verursacht werden, den erforderlichen Bewegungsspielraum zu ermöglichen.

Die Kontaktierungsmittel können hierbei erneut elastisch und elektrisch leitend, vorzugsweise als metallische Kontaktfeder, ausgebildet sein.

Eine andere Weiterbildung des erfindungsgemäßen Verbundbaugruppenträgers sieht vor, daß der Verbindungsrahmen mindestens ein Kontaktierungsmittel an der zur Vorderseite des Baugruppenträgers liegenden Kante aufweist, wobei das Kontaktierungsmittel zumindest die Unterseite des obenliegenden und die Oberseite des untenliegenden Baugruppenträgers kontaktiert. Bei geschlossener Frontabdeckung wird dieses Kontaktierungsmittel durch die Kontaktierungsmittel der Frontabdekkung zusätzlich angedrückt und kontaktiert, so daß der Verbindungsrahmen auch mit der Frontabdeckung elektrisch verbunden ist.

In vorteilhafter Weise ist das Kontaktierungsmittel U-förmig gebogen. Weiterhin ist auch die elektrische Leitfähigkeit, sowie Elastizität gegeben.

In einer weiteren vorteilhaften Ausführung des erfindungsgemäßen Verbundbaugruppenträgers besteht der Verbindungsrahmen, zumindest teilweise, aus einem C-Profil, wobei die Öffnung des C-Profils nach innen zeigt. Vorteilhaft ist in das C-Profil ein Befestigungsmittel versenkbar.

Weitere Merkmale der Erfindung ergeben sich aus der nachfolgenden Beschreibung unterschiedlicher Ausführungsbeispiele unter Bezugnahme auf die Zeichnungen. Es zeigen:
- Figur 1:: eine erste Variante des erfindungsgemäßen Verbundbaugruppenträgers bestehend aus zwei Baugruppenträgern;
- Figur 2:: einen Schnitt durch einen Teil des erfindungsgemäßen Verbundbaugruppenträgers;
- Figur 3:: einen Detailausschnitt mit Verbindungsrahmen und Kontaktfeder;
- Figur 4:: ein bevorzugtes Ausführungsbeispiel des erfindungsgemäßen Verbundbaugruppenträgers bestehend aus zwei Baugruppenträgern;
- Figur 5:: einen Detailausschnitt des bevorzugten Ausführungsbeispiels, wobei die Kontaktierung zweier Baugruppenträger gezeigt ist;
- Figur 6:: einen Schnitt durch einen Teil des erfindungsgemäßen Verbundbaugruppenträgers, wobei die Kontaktierung der Frontdeckel gezeigt ist;
- Figur 7:: einen Schnitt durch einen Teil des erfindungsgemäßen Verbundbaugruppenträgers, wobei die Kontaktierung einer Oberseite und einer Unterseite gezeigt ist;
- Figur 8:: einen Schnitt durch einen Teil des erfindungsgemäßen Verbundbaugruppenträgers, wobei die Kontaktierung der Frontdeckel mit dem Schirmblech gezeigt ist;
- Figur 9:: einen Schnitt durch einen Teil des erfindungsgemäßen Verbundbaugruppenträgers, wobei die Befestigung des Schirmblechs an der Unterseite gezeigt ist;.

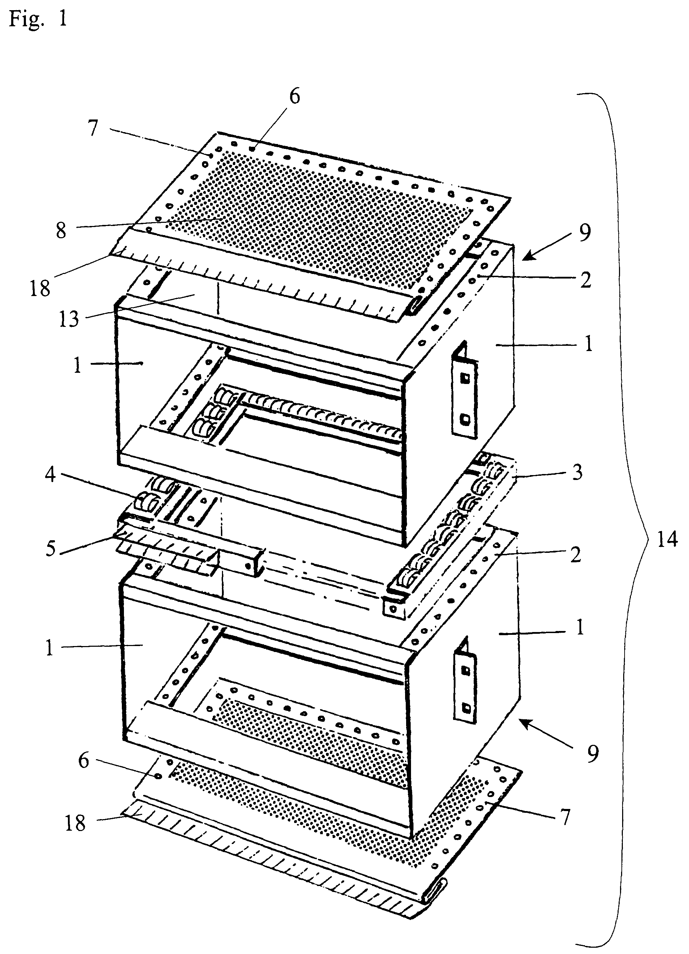

Die Figur 1 zeigt einen erfindungsgemäßen Verbundbaugruppenträger, der hier, für eine bessere Übersichtlichkeit, lediglich zwei Baugruppenträger enthält. Es versteht sich, daß der Verbundbaugruppenträger nach oben und unten erweiterbar ist.

Der Verbundbaugruppenträger 14 besteht im vorliegenden Ausführungsbeispiel aus zwei erfindungsgemäßen Baugruppenträgern 9, zwischen diesen Baugruppenträgern 9 einem Verbindungsrahmen 3 und am oberen und unteren Ende des Verbundbaugruppenträgers 14 zwei Schirmblechen 7.

Die beiden senkrechten Seitenwände 1 jedes Baugruppenträgers 9 sind am oberen und am unteren Rand der Seitenwand 1 um 90 Grad nach innen gebogen und bilden U-förmige Flächen, die auf der Ober- und auf der Unterseite des Baugruppenträgers 9 als randständige Stege 2 erscheinen. Diese Stege 2 sind in kurzen Abständen, also beispielsweise alle 25 mm, gelocht. Diese Löcher werden zum Anschrauben des paßgenauen Verbindungsrahmens 3 und der Schirmbleche 7 benötigt.

Der Verbindungsrahmen 3 fügt sich zwischen zwei benachbarte Baugruppenträger 9 ein, und wird allerdings lediglich mit einem der beiden Baugruppenträger 9, hier dem unteren der beiden, fest verbunden. Die Gegenseite des Verbindungsrahmens 3, also die Seite, die nicht mit dem Baugruppenträger 9 fest verbunden ist, ist mit einer Vielzahl von Kontaktfedern 4 bestückt und kontaktiert mit den Stegen 2 (mit der Flanschfläche) des oben liegenden Baugruppenträgers 9. Es ist wichtig, hier keine weitere starre Verbindung zu bilden, um zum Beispiel Toleranzen auszugleichen oder bei mechanischen Beanspruchungen den erforderlichen Bewegungsspielraum zu ermöglichen.

Eine Kontaktierung einer Frontabdeckung (hier nicht dargestellt) jedes Baugruppenträgers 9 wird von den U-förmig gebogenen Kontaktfedern 5 hergestellt, die als Bestandteil des Verbindungsrahmens 3 an seiner Frontseite angeordnet sind.

Die Ober- und die Unterseite des Baugruppenträgers 9 sind mit jeweils einem großflächigen Durchbruch 13 versehen und besitzen keinerlei elektrische Schirmfunktion. Zur Abschirmung wird ein Schirmblech 7 auf die Stege 2 der Oberseite des obenliegenden Baugruppenträgers 9 und ein weiteres Schirmblech 7 auf die Stege 2 der Unterseite des untenliegenden Baugruppenträgers 9 aufgeschraubt. Die randständig verlaufende Lochung 6 der Schirmbleche 7 ist hierbei deckungsgleich zu der Lochung 6 der Stege 2.

Die Frontkanten der Schirmbleche 7 tragen ebenfalls Kontaktfedern 18, die eine Verbindung zu dem jeweiligen Baugruppenträger 9 und zu der Frontabdeckung herstellen.

Die Perforation 8 der Schirmbleche 7, also die Offenheit, der Durchmesser der Löcher sowie die Ausdehnung der perforierten Fläche, sowie das Material kann variieren und den EMV- und Entwärmungsanforderungen entsprechend angepaßt werden.

Ein zusammengebauter Verbundbaugruppenträger 14 besitzt also keinerlei Zwischenböden, die eine freie Konvektion der Luft von unten nach oben behindern. Diese erfindungsgemäße Gestaltung wirkt ähnlich wie ein Kamin und bietet deshalb eine, im Vergleich zu bisherigem Standard, deutlich erhöhte Entwärmungskapazität.

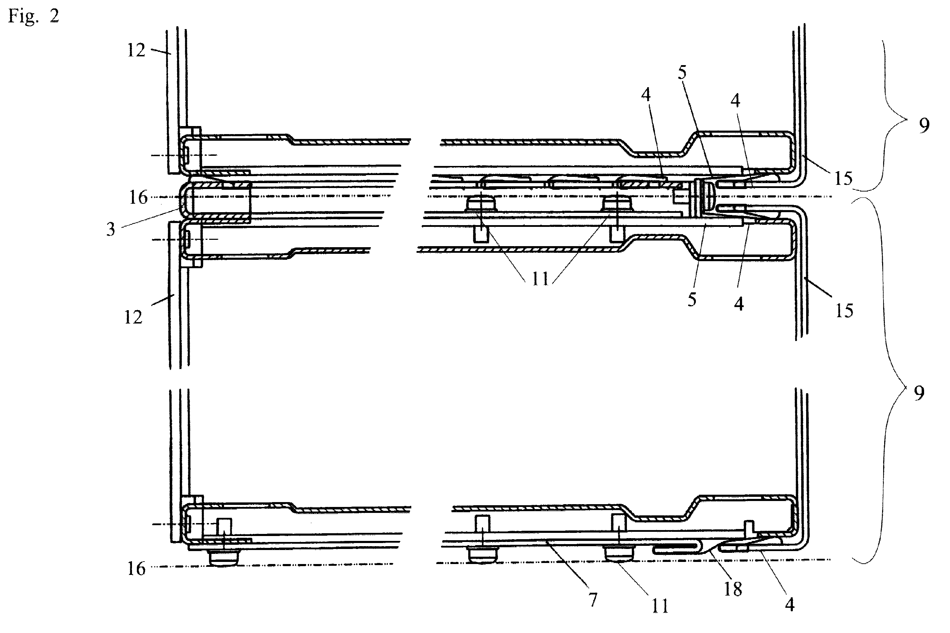

Die Figur 2 zeigt einen Schnitt entlang einer Seitenwand des erfindungsgemäßen Verbundbaugruppenträgers, wobei der untere Teil dargestellt ist. Die Teilungsgrenze zwischen zwei Baugruppenträgern 9 ist mit einer Strichpunktlinie 16 gezeigt.

Die Befestigung der einzelnen Teile des Verbundbaugruppenträgers sowie die elektrische Kontaktierung untereinander ist hier gut sichtbar.

Der Verbindungsrahmen 3 ist mit Schrauben 11 an dem unteren Baugruppenträger 9 befestigt. Die Kontaktfedern 4 auf der Oberseite des Verbindungsrahmens 3 kontaktieren den oberen Baugruppenträger 9. Die Kontaktierung der Frontabdeckung 15 stellt die an der Frontseite, in der Figur 2 auf der rechten Seite des Verbindungsrahmens 3, befindliche U-förmig gebogene Kontaktfeder 5 her. Diese Kontaktfeder 5 liegt auf beiden Baugruppenträgerflächen auf und wird bei geschlossenen Frontabdeckungen 15 durch deren Kontaktfedern 4 zusätzlich angedrückt und kontaktiert.

Die Figur 2 zeigt weiterhin die Befestigung des Schirmblechs 7 mit Hilfe von Schrauben 11 an dem Baugruppenträger 9. Die Kontaktierung des Schirmblechs 7 mit dem Baugruppenträger 9 sowie mit der Frontabdeckung 15 erfolgt über die Kontaktfedern 18 des Schirmblechs 7 sowie die Kontaktfedern 4 der Frontabdeckung 15.

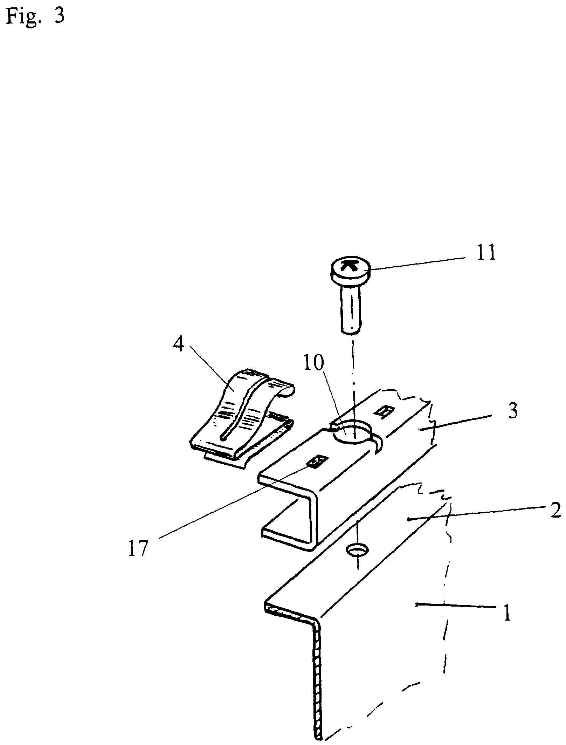

Die Figur 3 zeigt im Detail einige ausgewählte Komponenten des erfindungsgemäßen Verbundbaugruppenträgers. Die Kontaktfeder 4 ist hier in einem entspannten Zustand. Sie wird in die Vertiefung 17 auf der Oberseite des Verbindungsrahmens 3 aufgebracht, beispielsweise gesteckt.

Der Verbindungsrahmen 3 ist ein C-Profil, wobei die offene Seite dieses C-Profils zur Rahmeninnenseite hin (hier nach links) zeigt. Die Lochung 10 des Verbindungsrahmens 3 ist so ausgestaltet, daß eine Schraube 11 darin versenkbar ist, das heißt, die Bohrung auf der Oberseite des Verbindungsrahmens 3 ist für den Schraubenkopf durchgängig. Mit der Bohrung auf der Unterseite (hier durch das C-Profil verdeckt) wird der Verbindungsrahmen 3 auf dem Steg 2 festgeschraubt, der im rechten Winkel zur Seitenwand 1 des Baugruppenträgers steht.

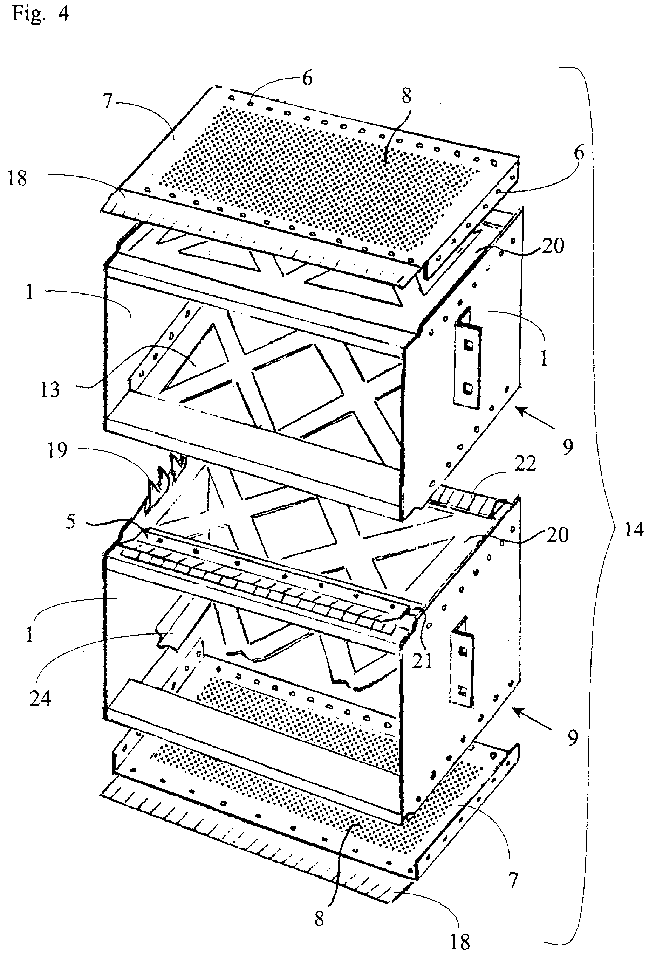

Die Figur 4 zeigt ein bevorzugtes Ausführungsbeispiel des erfindungsgemäßen Verbundbaugruppenträgers 14, der aus zwei Baugruppenträgern 9 sowie zwei Schirmblechen 7 besteht.

Im Vergleich zu der Figur 1 sind die Funktionen des Zwischenrahmens durch nachfolgend erläuterte Weiterbildungen in die Baugruppenträger 9 integriert worden.

Die beiden senkrechten Seitenwände 1 jedes Baugruppenträgers 9 sind am oberen und am unteren Rand der Seitenwand 1 in regelmäßigen Abständen gelocht.

Die nach oben und unten abschließenden Schirmbleche 7 besitzen, analog zu der Figur 1, eine großflächige Perforation 8, sowie an ihren Frontkanten Kontaktfedern 18. Zu den Seitenwänden 1 hin ist das Schirmblech 7 um 90 Grad nach unten gebogen. Diese Stege weisen in kurzen Abständen eine Lochung 6 auf, um ein Verschrauben mit den Seitenwänden 1 zu ermöglichen. Daneben ist auch eine Lochung 6 zur Rückwand hin und bei den Kontaktfedern 18 vorgesehen.

Die Oberseite 20 und die Unterseite 24 der Baugruppenträger 9 sind mit mehreren großflächigen Durchbrüchen 13 versehen. Um einen Blick auf das untere Schirmblech 7 zu gewähren, ist die Unterseite 24 des unteren Baugruppenträgers 9 nur zur Hälfte dargestellt.

Zur Kontaktierung beider Baugruppenträger 9 miteinander, trägt der untere Baugruppenträger 9 an seiner Oberseite 20 Federn 19. Diese Federn 19 sind auf die Blechkanten der beiden Seitenwände 1 des Baugruppenträgers 9 aufgebracht und bewirken eine elektrische Verbindung der Seitenwände 1 miteinander. Der Einfachheit halber sind hier lediglich die Federn 19 der linken Seitenwand 1 gezeigt. Weiterhin trägt dieser Baugruppenträger 9 entlang seiner oberen Frontseite Kontaktfedern 5, die auf einer Strebe 21 befestigt sind. Die Strebe 21 wiederum ist an der linken und der rechten Seitenwand 1 des Baugruppenträgers 9 befestigt. Zur Rückwand hin sind eine Reihe dreiecksförmiger Federn 22 vorgesehen, die die Baugruppenträger 9 miteinander kontaktieren.

Besteht der Verbundbaugruppenträger 14 aus noch weiteren Baugruppenträgern 9, enthalten alle, bis auf den obersten Baugruppenträger 9, die Federn 19, die dreiecksförmigen Federn 22 sowie die Kontaktfedern 5.

Diese Ausführung des erfindungsgemäßen Verbundbaugruppenträgers 14 stellt im Vergleich zu dem Ausführungsbeispiel der Figur 1 eine erhebliche Vereinfachung und Verbesserung dar, da hier ein Bauteil weniger (kein Zwischenrahmen) benötigt wird. Somit ist im Fertigungsprozeß lediglich ein einziger Grundkörper für den Baugruppenträger 9 sowie ein Grundkörper für das Schirmblech 7 herzustellen. Für die elektrische Kontaktierung können billige Kaufteile, die Kontaktierungsmittel 5, 19 und 22, aufgesteckt oder angeschraubt werden.

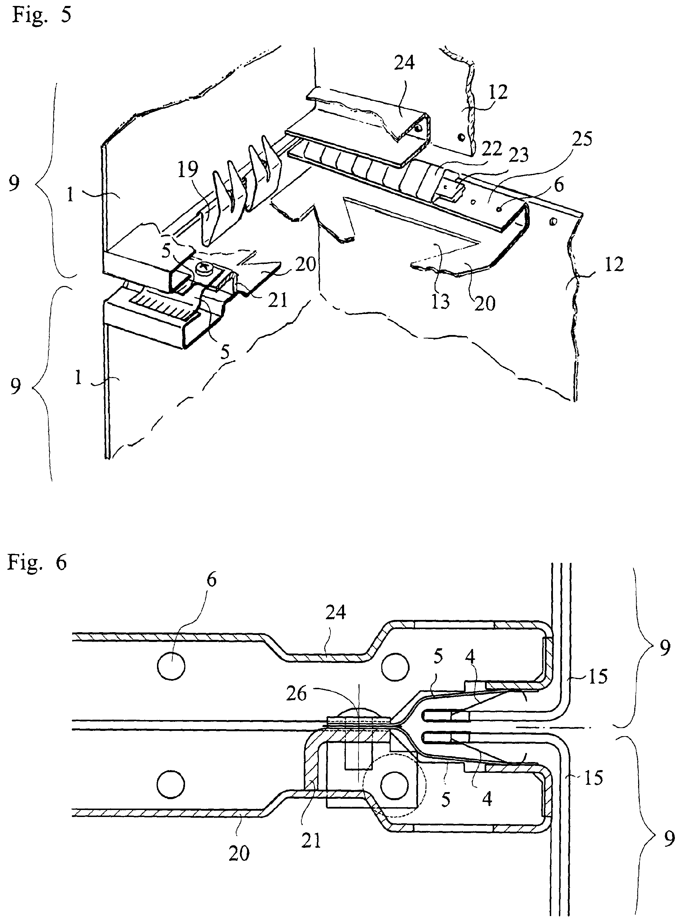

Die Figur 5 zeigt einen Detailausschnitt aus dem Verbundbaugruppenträger mit relevanten elektrischen Kontaktstellen zur Kontaktierung der beiden erfindungsgemäßen Baugruppenträger 9.

Frontseitig kontaktieren zwei gemeinsam montierte, kammförmige Kontaktfedern 5 die beiden Baugruppenträger 9 miteinander, wobei die obere der Kontaktfedern 5 die Unterseite 24 des obenliegenden Baugruppenträgers 9, die untere Kontaktfeder 5 die Oberseite 20 des untenliegenden Baugruppenträgers 9 kontaktiert. Die Kontaktfedern 5 sind mittels einer Schraube an einer Strebe 21 montiert, die zwischen den beiden Seitenteilen 1 an der Oberseite 20 des Baugruppenträgers 9 verläuft.

Die elektrische Verbindung der Seitenteile 1 zweier nachbarständiger Baugruppenträger 9 miteinander, erfolgt über Federn 19, die auf die Blechkanten der Seitenteile 1 des unteren Baugruppenträgers 9 aufgeschnappt sind. Die fingerförmigen Zungen dieser Federn 19 drücken gegen das Seitenteil 1 des angesetzten oberen Baugruppenträgers 9.

Zur Rückwand 12 hin, also backplaneseitig, werden die Baugruppenträger 9 mittels dreiecksförmiger Federn 22 miteinander kontaktiert. Diese dreiecksförmigen Federn 22 sind mittels einer Schiene 23 so gehalten, daß sie gut einfedern können, wenn sie mit ihrer giebelförmigen Spitze vom Bodenblech 20 des obenliegenden Baugruppenträgers niedergedrückt werden.

Die Figur 5 zeigt weiterhin einen Teil der Oberseite 20 des Baugruppenträgers 9 mit einem großflächigen Durchbruch 13. Hierbei ist die Oberseite 20 rückwandseitig U-förmig nach oben gebogen, so daß sich ein Steg 25 ausbildet. Dieser Steg 25 ist in kurzen Abständen mit einer Lochung 6 versehen, so daß die Schiene 23 auf den Steg 25 aufgeschraubt werden kann.

Die Figur 6 zeigt einen Schnitt entlang einer Seitenwand des Verbundbaugruppenträgers. Hier wird die Kontaktierung der Frontabdeckung 15 mit den einzelnen Baugruppenträgern 9 detaillierter gezeigt. Die Kontaktkräfte werden bei geschlossenen Frontabdeckungen 15, also im Betriebszustand über die Kontaktfedern 4 der Frontabdeckung 15 verstärkt, wie dies schon in der Figur 2 näher beschrieben ist. Die geschlossene Frontabdeckung 15 ist gleichzeitig über seine Kontaktfedern 4 durchgehend elektrisch mit der frontseitigen Kante des Baugruppenträgers 9 verbunden.

Die beiden Kontaktfedern 5 sind auf einer Strebe 21 mittels einer Schraube 26 befestigt. Diese Strebe 21 ist wiederum an der linken und rechten Seitenwand 1 des Baugruppenträgers 9 befestigt. Zur besseren Stabilität ist die Strebe 21 als Winkelprofil ausgebildet und stützt sich auf der Oberseite 20 des Baugruppenträgers ab. Somit kann verhindert werden, daß sich die Strebe 21 verdrillt oder durchhängt, ohne daß ein sehr dickes Material benötigt wird.

Die Kreise 6 zeigen die Lochung an den Seitenwänden der Baugruppenträger 9.

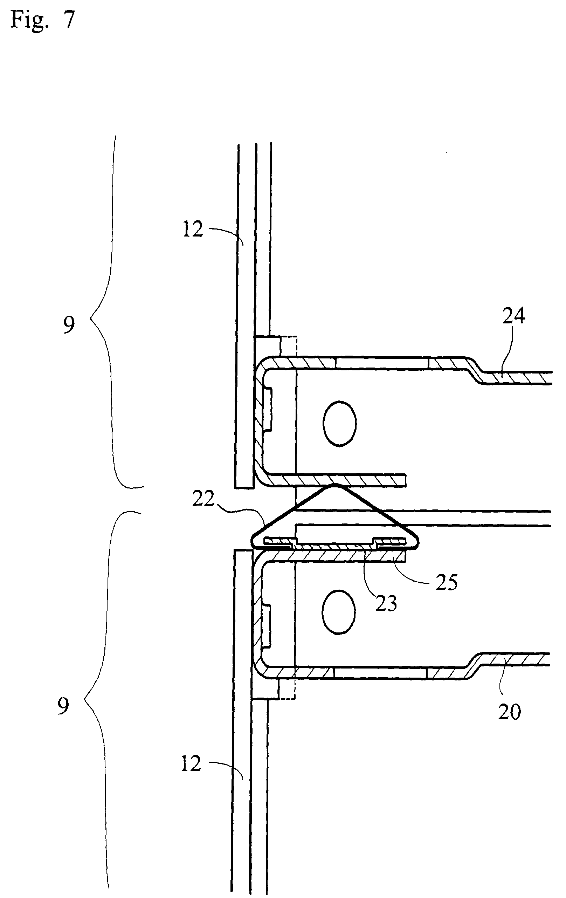

Die Figur 7 zeigt erneut einen Schnitt durch die Seitenwand 1 des erfindungsgemäßen Verbundbaugruppenträgers, wobei ein Teil der Rückwand 12, der Unterseite 24 des obenliegenden Baugruppenträgers 9, der Oberseite 20 des untenliegenden Baugruppenträgers 9 sowie die dreiecksförmige Feder 22 dargestellt sind. Zur Rückwand 12 hin werden die Baugruppenträger 9 mittels dieser dreiecksförmigen Federn 22 miteinander kontaktiert, wobei die giebelförmige Spitze der Feder 22 die Unterseite 24 berührt. Die Feder 22 wird mittels einer Schiene 23, die auf dem Steg 25 befestigt ist, so gehalten, daß sie gut einfedern kann, wenn sie von der Unterseite 24 des obenliegenden Baugruppenträgers 9 niedergedrückt wird.

Auch hier ist das C-Profil der Unterseite 24 und der Oberseite 20 der Baugruppenträger 9 zu erkennen.

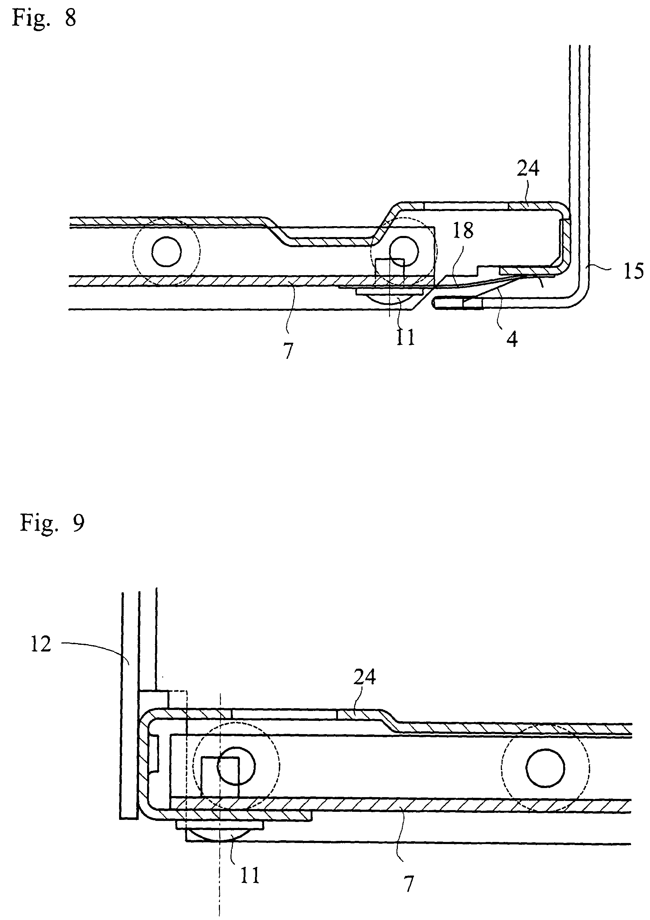

Die Figur 8 zeigt erneut einen Schnitt durch eine Seitenwand des Baugruppenträgers 9, wobei die Kontaktierung der Frontabdeckung 15 mit der Unterseite 24 des untersten Baugruppenträgers 9 sowie mit dem Schirmblech 7 eines Verbundbaugruppenträgers dargestellt ist.

Frontseitig, in der Figur 8 nach rechts zeigend, ist eine kammförmige Kontaktfeder 18 an der Kante des Schirmbleches 7 mit gutem elektrischen Kontakt mittels einer Schraube 11 befestigt. Die Kontaktfeder 18 liegt auf dem Schirmblech 7 über die volle Länge auf, wie dies aus der Figur 4 ersichtlich ist. Auch hier wird bei geschlossener Frontabdeckung 15 die Kontaktierung der Kontaktfedern 4 mit der Unterseite 24 des Baugruppenträgers 9 über die Kontaktfedern 18 verstärkt.

Die Figur 9 zeigt die Verschraubung des nach unten abschlieβenden Schirmblechs 7 mit der Seitenwand (hier Schnitt durch eine Seitenwand) sowie zu der Rückwand 12 hin, mit der Unterseite 24 des Baugruppenträgers 9 mittels Schrauben 11 in kurzen Abständen (zirka 20 bis 30 mm). Der kurze Abstand resultiert nicht aus mechanischen Gründen, sondern sollte wegen einer guten HF-Schirmung möglichst klein gehalten werden.

Es ist hervorzuheben, daß die Anordnung der elektrischen Verbindungen von Baugruppenträger zu Baugruppenträger kleine Verschiebungen untereinander erlaubt, wie sie zum Beispiel durch Erdbeben hervorgerufen werden, ohne Kontaktunterbrechung.

Es versteht sich, daß die vorstehend genannten Merkmale der Erfindung nicht nur in der jeweils angegebenen Kombination, sondern auch in anderen Kombinationen oder in Alleinstellung verwendbar sind, ohne den Rahmen der Erfindung zu verlassen.

Insgesamt wird durch die Erfindung ein Baugruppenträger und ein Verbundbaugruppenträger vorgestellt, die eine verbesserte Entwärmbarkeit von Baugruppen, die in dem Baugruppenträger angeordnet sind, bewirken.

## Patentansprüche

1. Baugruppenträger (9) für einen Verbundbaugruppenträger (14) mit zwei Seitenwänden (1), einer Oberseite (20), einer Unterseite (24), einer Vorderseite und einer Rückwand (12), zur Aufnahme von Baugruppen, **dadurch gekennzeichnet, daß** sowohl die Oberseite (20) als auch die Unterseite (24) des Baugruppenträgers (9) jeweils mit mindestens einem großflächigen Durchbruch (13) versehen sind.

2. Baugruppenträger (9) gemäß dem voranstehenden Anspruch 1, **dadurch gekennzeichnet, daß** die Fläche des mindestens einen Durchbruchs (13) zwischen 50% und 90%, vorzugsweise zwischen 70% und 90%, der gesamten Fläche der Oberseite (20) oder der Unterseite (24) des Baugruppenträgers (9) aufweist.

3. Baugruppenträger (9) gemäß einem der voranstehenden Ansprüche 1 bis 2, **dadurch gekennzeichnet, daß** vorzugsweise randständige Stege (2) auf der Oberseite (20) und auf der Unterseite (20) des Baugruppenträgers (9) vorgesehen sind.

4. Baugruppenträger (9) gemäß dem voranstehenden Anspruch 3, **dadurch gekennzeichnet, daß** die Stege (2), zumindest teilweise, eine Lochung (6) aufweisen.

5. Baugruppenträger (9) gemäß einem der voranstehenden Ansprüche 1 bis 4, **dadurch gekennzeichnet, daß** auf der zur Oberseite (20) gelegenen Kante jeder Seitenwand (1) des Baugruppenträgers (9) Kontaktierungsmittel (19) vorgesehen sind.

6. Baugruppenträger (9) gemäß einem der voranstehenden Ansprüche 1 bis 5, **dadurch gekennzeichnet, daß** auf der Oberseite (20), zur Vorderseite des Baugruppenträgers (9) hin gelegen, Kontaktierungsmittel (5) vorgesehen sind.

7. Baugruppenträger (9) gemäß einem der voranstehenden Ansprüche 1 bis 6, **dadurch gekennzeichnet, daß** auf der Oberseite (20), zur Rückwand (12) des Baugruppenträgers (9) hin gelegen, weitere Kontaktierungsmittel (22) vorgesehen sind.

8. Baugruppenträger (9) gemäß einem der voranstehenden Ansprüche 1 bis 7, **dadurch gekennzeichnet, daß** eine Frontabdeckung (15) mit Kontaktierungsmitteln (4) vorgesehen ist, die den Baugruppenträger (9) kontaktieren.

9. Baugruppenträger (9) gemäß einem der voranstehenden Ansprüche 5 bis 8, **dadurch gekennzeichnet, daß** das Kontaktierungsmittel (4, 5, 19, 22), zumindest teilweise, elastisch und elektrisch leitend ausgebildet ist.

10. Baugruppenträger (9) gemäß dem voranstehenden Anspruch 9, **dadurch gekennzeichnet, daß** das Kontaktierungsmittel (4, 5, 19, 22) eine, vorzugsweise metallische, Kontaktfeder darstellt.

11. Baugruppenträger (9) gemäß einem der voranstehenden Ansprüche 1 bis 10, **dadurch gekennzeichnet, daß** mindestens ein, vorzugsweise zwei Schirmbleche (7) vorgesehen sind, die den mindestens einen großflächigen Durchbruch (13) der Oberseite (20) und/oder der Unterseite (24) des Baugruppenträgers (9) abschirmen.

12. Baugruppenträger (9) gemäß dem voranstehenden Anspruch 11, **dadurch gekennzeichnet, daß** das Schirmblech (7), zumindest teilweise, eine Lochung (6) aufweist.

13. Baugruppenträger (9) gemäß einem der voranstehenden Ansprüche 11 bis 12, **dadurch gekennzeichnet, daß** das Schirmblech (7) eine Vielzahl von regelmäßig verteilten Löchern (8) aufweist, wobei die gesamte offene Fläche der Löcher (8) zwischen 50% und 80%, vorzugsweise zwischen 65% und 75%, der gesamten Fläche des Schirmblechs (7) liegt.

14. Baugruppenträger (9) gemäß einem der voranstehenden Ansprüche 11 bis 13, **dadurch gekennzeichnet, daß** das Schirmblech (7), zumindest an der zur Vorderseite des Baugruppenträgers (9) weisenden Kante, mindestens ein, vorzugsweise mehrere, Kontaktierungsmittel (18), zur Kontaktierung des Schirmblechs (7) zumindest mit dem Baugruppenträger (9), aufweist.

15. Verbundbaugruppenträger (14) mit zumindest zwei senkrecht übereinander angeordneten Baugruppenträgern (9), wobei die Baugruppenträger (9) zwei Seitenwände (1), eine Oberseite (20), eine Unterseite (24), eine Vorderseite und eine Rückwand (12) aufweisen, zur Aufnahme von Baugruppen, **dadurch gekennzeichnet, daß** mindestens zwei Baugruppenträger (9), vorzugsweise alle Baugruppenträger (9), gemäß einem der Merkmale der voranstehenden Ansprüche 1 bis 10 ausgebildet sind und zwei Schirmbleche (7), gemäß einem der Merkmale der voranstehenden Ansprüche 12 bis 14 vorgesehen sind, die die Oberseite (20) des obenliegenden Baugruppenträgers (9) und die Unterseite (24) des untenliegenden Baugruppenträgers (9) abschirmen.

16. Verbundbaugruppenträger (14) gemäß dem voranstehenden Anspruch 15, **dadurch gekennzeichnet, daß** zwischen zwei Baugruppenträgern (9) ein Verbindungsrahmen (3) vorgesehen ist.

17. Verbundbaugruppenträger (14) gemäß dem voranstehenden Anspruch 16, **dadurch gekennzeichnet, daß** der Verbindungsrahmen (3), zumindest teilweise, eine Lochung (10) zur Befestigung an einem Baugruppenträger (9) aufweist.

18. Verbundbaugruppenträger (14) gemäß einem der voranstehenden Ansprüche 16 bis 17, **dadurch gekennzeichnet, daß** der Verbindungsrahmen (3) eine Vielzahl von Kontaktierungsmitteln (4) aufweist, die an der Oberseite oder an der Unterseite des Verbindungsrahmens (3) angeordnet sind.

19. Verbundbaugruppenträger (14) gemäß dem voranstehenden Anspruch 18, **dadurch gekennzeichnet, daß** die Kontaktierungsmittel (4), gemäß einem der Merkmale der Ansprüche 6 und/oder 7 ausgebildet sind.

20. Verbundbaugruppenträger (14) gemäß einem der voranstehenden Ansprüche 16 bis 19, **dadurch gekennzeichnet, daß** der Verbindungsrahmen (3) mindestens ein Kontaktierungsmittel (5) an der zur Vorderseite des Baugruppenträgers (9) liegenden Kante aufweist, wobei das Kontaktierungsmittel (5) zumindest die Unterseite des obenliegenden und die Oberseite des untenliegenden Baugruppenträgers (9) kontaktiert.

21. Verbundbaugruppenträger (14) gemäß einem der voranstehenden Ansprüche 16 bis 20, **dadurch gekennzeichnet, daß** der Verbindungsrahmen (3), zumindest teilweise, aus einem C-Profil besteht, wobei die Öffnung des C-Profils nach innen zeigt.

22. Verbundbaugruppenträger (14) gemäß dem voranstehenden Anspruch 21, **dadurch gekennzeichnet, daß** in das C-Profil ein Befestigungsmittel (11) versenkbar ist.
